Europäisches Patentamt

European Patent Office

Office européen des brevets

(11) Publication number: **0 093 565**

**B1**

(12) **EUROPEAN PATENT SPECIFICATION**

(45) Date of publication of patent specification: 04.01.89

(21) Application number: **83302351.8**

(22) Date of filing: **26.04.83**

(51) Int. Cl.⁴: **H 03 K 17/96**

(54) **Touch sensing device.**

(30) Priority: **30.04.82 JP 73785/82**

(43) Date of publication of application:
**09.11.83 Bulletin 83/45**

(45) Publication of the grant of the patent:
**04.01.89 Bulletin 89/01**

(84) Designated Contracting States:
**DE FR GB IT NL**

(56) References cited:
**EP-A-0 023 271**
**EP-A-0 078 676**

**IBM TECHNICAL DISCLOSURE BULLETIN, vol.
3, no. 11, April 1961, page 31, New York, US;
W.A. GODDARD: "Non-mechanical keyboard"
Idem**

**IBM TECHNICAL DISCLOSURE BULLETIN, vol.
24, no. 5, October 1981, pages 2237-2240, New
York, US; E.G. CRABTREE: "Capacitive
keyboard FET sense circuit"
Idem**

(73) Proprietor: **FUJITSU LIMITED**
**1015, Kamikodanaka Nakahara-ku**
**Kawasaki-shi Kanagawa 211 (JP)**

(72) Inventor: **Yoshikawa, Kazuo c/o Fujitsu Limited**
**Patent Department 1015 Kamikodanaka**
**Nakahara-ku Kawasaki 211 (JP)**
Inventor: **Yamaguchi, Hisashi c/o Fujitsu**
**Limited**
**Patent Department 1015 Kamikodanaka**
**Nakahara-ku Kawasaki 211 (JP)**
Inventor: **Asano, Toru c/o Fujitsu Limited**
**Patent Department 1015 Kamikodanaka**
**Nakahara-ku Kawasaki 211 (JP)**

(74) Representative: **Sunderland, James Harry et al**
**HASELTINE LAKE & CO Hazlitt House 28**
**Southampton Buildings Chancery Lane**
**London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a touch sensing device.

A see-through type touch sensing device has been proposed for use for inputting data, relating to a display at an area on a display screen and designated by a finger touch, to a computer system. A touch sensing device has been proposed which is capable of detecting a change in capacitance of a touch sensing electrode occurring as a result of a finger touch.

As a man-machine interface unit there has been proposed a see-through type touch keyboard for mounting over a display screen and for use in inputting to a computer data corresponding to an area designated by finger touch on the keyboard. It is important for such a touch keyboard that the touch condition is accurately and stably sensed, and various methods have been proposed for achieving this.

In one proposed touch sensing method, a change of capacitance between a touch sensing electrode and the ground caused by a finger touching the electrode is measured. Such a method is described in U.S. Patent No. 3,482,241.

The U.S. Patent describes a method of measuring a change of capacitance in relation to a touch sensing electrode by utilizing an AC bridge circuit, whilst the U.S. Patent application describes a method of measuring such a change utilizing a resonance phenomenon in a resonant circuit.

The principle behind a method of measuring change of capacitance in relation to a touch sensing electrode by utilizing a resonance phenomenon of a resonant circuit is briefly described hereunder.

This method utilises the fact that the resonance condition of a resonant circuit changes in accordance with change of capacitance associated with the circuit. An oscillator circuit which generates an AC signal of a predetermined frequency is connected to a touch sensing electrode, and a resonant circuit tuned to the frequency of the AC signal is connected between the touch sensing electrode and ground. With such a structure, the resonance condition of resonant circuit is changed in accordance with the touch/non-touch condition of the touch sensing electrode upon which condition capacitance of the electrode depends—and thereby an output voltage at the connecting point between the oscillating circuit and resonant circuit is changed.

However, in the previously proposed method for detecting the touch condition of a touch sensing electrode by measuring a change of capacitance at such a touch sensing electrode, the possibility of different touch sensing electrodes providing different capacitances in the same, touch or non-touch, condition is not considered. If such differences arise, different resonance conditions of a resonant circuit will be provided in accordance with the sensing of different touch sensing electrodes, resulting in the disadvantage that accurate and stable sensing might not be obtained and resultant input errors caused.

This disadvantage could arise not only in a method of measuring change of capacitance associated with a touch sensing electrode by utilising a resonance phenomenon of a resonant circuit but also in a method of measuring change of capacitance by utilising an AC bridge circuit.

Possible causes of different touch sensing electrode capacitances are production errors, differences in length of leads connected to the touch sensing electrodes, and variations in floating capacity between touch sensing electrodes.

Attention is directed to EP—A—0 078 676 which forms part of the state of the art by virtue of Article 54(3) EPC. This document discloses a touch sensing device, comprising a plurality of touch electrodes each of which can be designated by an object, for example a human finger, to bring about a change in electrical characteristics associated with the electrode, and a sensing portion to which the touch electrodes are selectively connectable, operable to sense a change in electrical characteristics when a touch electrode is designated by the object, the sensing portion comprising an oscillator, parallel resonant circuit tuned to the oscillation frequency of the oscillator and connected to the oscillator via an impedance element, and a circuit for sensing voltage change at the connection point of the parallel resonant circuit and the impedance element, the touch electrodes being selectively connectable to that connection point.

EP—A—0 023 271 discloses a capacitive touch sensing device with a plurality of touch electrodes each of which can be designated by an object, for example a human finger, to bring about a change in capacitance associated with the touch electrode, and a sensing portion, to which the touch electrodes are connected, operable to sense such a change in capacitance.

In the sensing portion a selection circuit has a variable threshold level which level is selected in dependence upon the output of a decoder which receives a binary signal, from a microcomputer, indicating the level desired.

IBM TDB, Vol. 24, No. 5, October 1981, pages 2237 to 2240, discloses a "Capacitive keyboard FET sense circuit". In this circuit compensating circuitry (C9) is provided for ensuring that when key status is sensed the potential on a sensing line will move either slightly negative or slightly positive (from zero volts), by generally equal amounts, in dependence upon whether a keyboard key is depressed or not depressed.

The compensating circuitry comprises four capacitors which are selectively connectable to the sensing line, to provide a selected value for a reference capacitance provided by the compensating circuitry.

According to the present invention there is provided a touch sensing device, comprising
a plurality of touch electrodes each of which can be designated by an object, for example a human finger, to bring about a change in electrical characteristics associated with the electrode;

a sensing portion to which the touch electrodes are selectively connectable, operable to sense a change in electrical characteristics when a touch electrode is designated by the object, the sensing portion comprising an oscillator, a parallel resonant circuit tuned to the oscillation frequency of the oscillator and connected to the oscillator via an impedance element, and a circuit for sensing voltage change at the connection point of the parallel resonant circuit and the impedance element, the touch electrodes being selectively connectable to that connection point;

compensating circuitry, having compensating circuit elements selectively connectable to the sensing portion to compensate for unwanted differences in electrical characteristics between touch electrodes; and

selection means operable to make selections of the compensating circuit elements, for connection to the sensing portion, appropriate to provide such compensation, in correspondence to selection of touch electrodes for connection to the sensing portion.

An embodiment of the present invention can provide a touch sensing device capable of accurately and stably sensing the touch condition of a touch sensing electrode.

An embodiment of the present invention can provide a touch sensing device which is not prone to mistakes in operation, the capacity of each touch sensing electrode being compensated so that the effective capacities of all the electrodes are practically equal.

An embodiment of the present invention can provide a compensating means capable of compensating for differences in the capacities of the sensing electrodes which is relatively simple and which uses a number of compensating capacitors less than the number of touch sensing electrodes.

Briefly, an embodiment of the present invention comprises a plurality of touch sensing electrodes, arranged in correspondence to locations where sensing is to be provided, and a sensing portion which senses a change in electrical characteristics of the pertinent touch sensing electrode when a designating operation (e.g. touching) is carried out on that touch sensing electrode, and moreover provides, for compensating for differences in electrical characteristics of the touch sensing electrodes, a plurality of compensating circuit elements which are used as common compensating circuit elements for all the touch sensing electrodes of the plurality, and memory elements storing data for selecting compensating circuit elements as appropriate to provide a compensating value, in accordance with the differences of electrical characteristics of the touch sensing electrodes, and also selectively connects, at the time of retrieving or reading each touch sensing electrode, the elements corresponding to the compensated value in the compensating circuit appropriate to the retrieved or read touch sensing electrode in accordance with the data stored in the memory element.

Reference is made, by way of example, to the accompanying drawings, in which:—

Fig. 1 is a schematic block diagram illustrating a touch sensing device embodying the present invention,

Fig. 2(a) is a block diagram of an arrangement for determining data to be stored in the ROM (114) used in the embodiment of Fig. 1,

Fig. 2(b) is a flowchart for assistance in explaining operations for determining data to be stored in the ROM (114) used in the embodiment of Fig. 1,

Fig. 2(c) is a table illustrating an example of data stored in the ROM (114) of Fig. 1.

Fig. 3(a) is a graph illustrating characteristics indicating the relationship between frequency and sensed voltage level obtained without compensation in accordance with an embodiment of the present invention,

Fig. 3(b) is a graph illustrating characteristics indicating the relationship between frequency and sensed voltage level with compensation in general accordance with the embodiment of the present invention of Fig. 1,

Fig. 4 is a schematic block diagram illustrating another touch sensing device embodying the present invention, and

Fig. 5 is a schematic block diagram illustrating a further touch sensing device embodying the present invention.

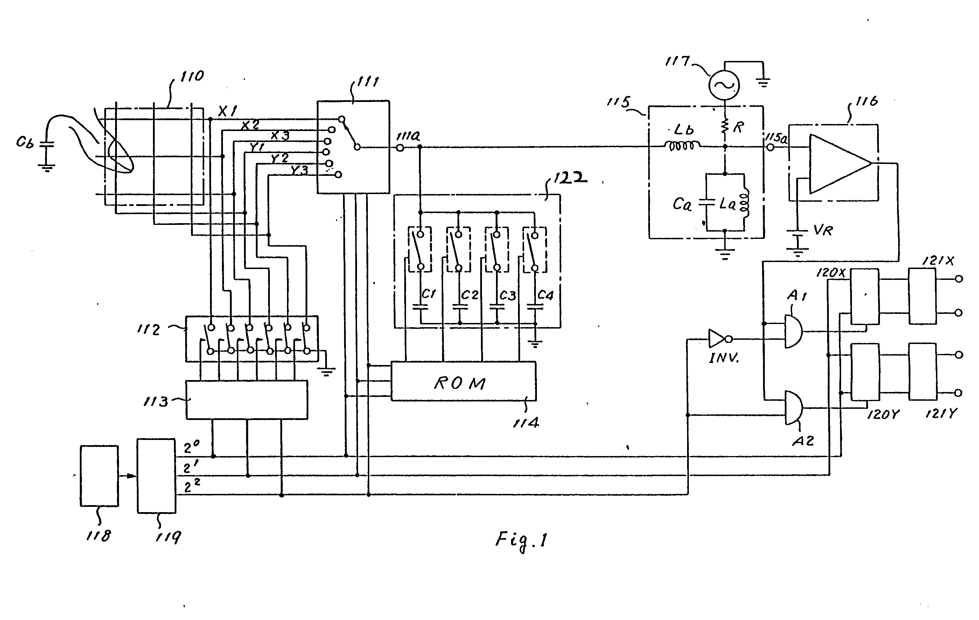

Fig. 1 is a block diagram illustrating a touch sensing device in accordance with an embodiment of the present invention.

A touch panel 110 provides respective pluralities of X and Y sensing electrodes, X1 to X3 and Y1 to Y3 (to form a 3×3 electrode array in this example). The electrodes are connected to a multiplexer 111 and an analog switch array 112. An output terminal 111a of the multiplexer 111 is connected to a sensing circuit 115 utilising a parallel series composite resonance circuit and an output terminal 115a of which is connected to a comparator 116 which compares the output voltage level of the resonance circuit with a reference voltage $V_R$.

The sensing circuit 115 comprises coils $L_a$ and $L_b$, a capacitor $C_a$ and a resistor R. The capacitor $C_a$ and coil $L_a$ form a parallel resonant circuit, whilst a capacitor Cb, for example representing a body capacitance of an operator who operates the touch panel, and the coil $L_b$ form a series resonant circuit.

To the sensing circuit 115, an AC signal of a constant frequency (for example, 12.5 kHz) is supplied from an oscillator 117. The parallel resonant circuit and series resonant circuit are designed in such a manner as to be tuned to the oscillation frequency of the oscillator.

The multiplexer 111 is sequentially switched so that the sensing electrodes X1 to X3 and Y1 to Y3 are connected one at a time in turn to sensing circuit 115.

A clock signal generator 118 and a 3-bit counter 119 generate address signals for switching the multiplexer 111 which has a decoding function so that the sensing electrodes are connected one by one to the sensing circuit 115 in accordance with the state of the address signal output from the counter 119.

On the other hand, the address signals from the counter 119 are also input to a decoder 113. Each address signal is decoded by the decoder 113 and the analog switch array 112 is controlled in dependence thereupon. The analog switch array 112 operates for connecting all sensing electrodes to the ground, except only for that one sensing electrodes which is presently connected to the sensing circuit 115 via the multiplexer 111. Influence of capacitance between sensing electrodes can be alleviated by such clamping of 'non-selected' electrodes to ground potential.

An output of comparator 116, which receives a sense signal from the sensing circuit 115, is connected to one input terminal of each of a pair of AND gates A1 and A2. The one AND gate A1 outputs a touch signal in relation to X sensing electrodes, when a signal obtained by inversion (through an inverter INV) in relation to an address signal matches the sense output signal of the comparator.

In more detail, in this case the three bit counter 119 provides 3-bit address signals along lines labelled $2^0$, $2^1$ and $2^2$ in Fig. 1. The AND gate A1 is connected to receive the inverted address signal bit on line $2^2$. It is prearranged that when this bit is "0" (and hence the inverted·bit supplied to AND gate A1 is "1") the multiplexer is connecting an X electrode to sensing circuit 115. Thus, when comparator 116 simultaneously delivers a "1" signal (indicating that a touch has been sensed in relation to the relevant X electrode) the AND gate A1 delivers a "1" output signal—a touch signal. The other AND gate A2 outputs, in a similar way, a touch signal for the Y sensing electrodes.

The AND gate A2 receives the address signal bit on line $2^2$ in uninverted form. It is prearranged that when this bit is "1" the multiplexer is connecting a Y electrode to sensing circuit 115. When capacitor 116 simultaneously delivers a "1" signal indicating that a touch has been sensed in relation to the relevant Y electrode the AND gate A2 delivers a "1" output signal.

Output signals of (touch signals from) the AND gates A1 and A2 are respectively output temporarily to the registers 120X, 120Y and used to store therein the address signal at the time when the touch signals are generated. That is, upon receipt of a touch signal from an AND gate (A1 or A2) the relevant register (120X or 120Y) is set to hold the address bits on lines $2^0$ and $2^1$ (to which lines the registers are connected) which identify the relevant electrode (X or Y electrode) in respect of which a touch has been sensed.

The data stored in the registers 120X and 120Y is read by output registers 121X, 121Y when the scanning of one cycle (period) of the X and Y sensing electrodes is complete and then sent to a computer as the address information indicating the finger-touched electrode location.

Address signals output from the 3-bit counter 119 are also input to a ROM (Read Only Memory) 114 having a decoding function, with a view to realising capacitance compensation in accordance with this embodiment of the present invention. The ROM 114 has stored therein in advance data for selecting signal .levels at each of a plurality of output terminals thereof to be either HIGH LEVEL or LOW LEVEL in accordance with the address signal input thereto.

A compensating circuit 122 comprises a plurality of switch elements and a plurality of compensating capacitors $C_1$ to $C_4$. One end of each switch element is connected to the output terminal 111a of multiplexer 111 so that those ends of the switch elements are connected in common. The other end of each switch element is connected to earth via a respective one of the compensating capacitors $C_1$ to $C_4$. The plurality of output terminals of the ROM 114 are independently connected to the switch elements of compensating circuit 122 (i.e. each ROM output terminal is connected to a respective switch element) and each switch element closes or opens in accordance with the output terminal level at the ROM output terminal connected thereto being HIGH LEVEL or LOW LEVEL.

Therefore, when the ROM 114 controls the compensating circuit 122 so that one or more of its switch elements close, in synchronization with the scanning of touch sensing electrodes X1 to X3, Y1 to Y3, compensation is effected in such a manner that the effective capacitance values of the touch sensing electrodes become equal. The ROM 114 stores data such that in response to each address signal indicating a particular sensing electrode, its output terminals are set at levels (HIGH LEVEL or LOW LEVEL) which operate switch elements of the compensating circuit to connect appropriate compensating capacitors to the input of sensing circuit 115 so that the effective capacitance value of the particular touch sensing electrode, which is connected to the sensing circuit 115 and designated by the address signal, is equal to a corrected capacitance value which is the same for all sensing electrodes.

It is possible to set the capacitance values of compensating capacitors $C_1$ to $C_4$ in accordance with the degree of fluctuation or variation of the capacitances of the sensing electrodes.

For example, compensation using 16 different compensation levels can be realised by setting a unit or basic compensating value with reference to the minimum required compensating capacitance and by setting the other capacitances in accordance with the ratios of 1:2:4:8. Therefore, capacitance compensation can be realised for all sensing electrodes with a number of compensating capacitors less than the number of touch sensing electrodes.

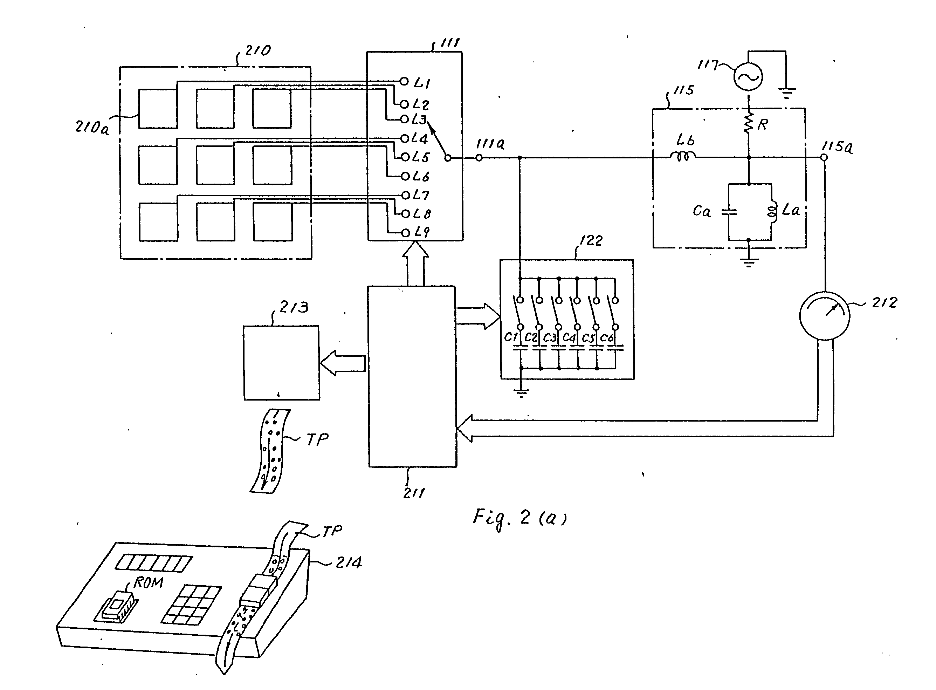

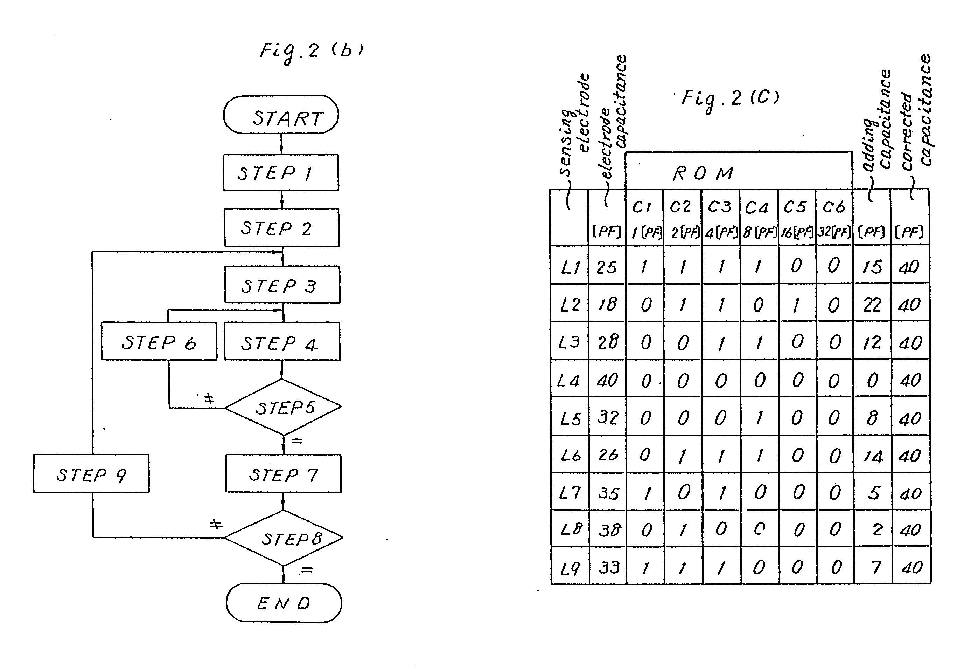

Fig. 2(a) is the block diagram of an arrangement for determining data to be stored in the ROM 114, shown in Fig. 1, for achieving compensation.

A touch panel 210 is divided into a plurality of touch areas 210a (in this case, nine sensing electrodes $L_1$ to $L_9$, corresponding to respective

touch areas, are indicated) and each sensing electrode corresponding to a touch area is independently connected to the multiplexer 111. The touch sensing electrodes $L_1$ to $L_9$ are sequentially scanned one by one by means of a scanning signal sent from a control circuit 211. The output terminal 111a of multiplexer 111 is connected to the sensing circuit 115, while the output terminal 115a of the sensing circuit 115 is connected to a level meter 212. In Fig. 2(a) the compensating circuit 122 is shown to have six switch elements and six compensating capacitance elements $C_1$ to $C_6$. The switch elements of compensating circuit 122 which, with respective compensating capacitors $C_1$ to $C_6$, are connected between the output terminal 111a and earth are controlled so as to be ON and OFF by the control circuit 211. In this case, the total of six compensating capacitors have respective capacitance of 1pF, 2pF, 4pF, 8pF, 16pF and 32pF, for example, and fluctuation of capacitances from 1 to 63 pF can be compensated by selected combinations of these capacitors. A tape puncher 213 punches data sent from the control circuit 211 on the paper tape TP. The data stored on the paper tape is stored in the ROM by a ROM writer 214.

Fig. 2(b) is a flowchart for assistance in explaining operations for determining data to be stored in the ROM 114, corresponding to operation of the control circuit 211 shown in Fig. 2(a).

Upon starting, the control circuit 211 outputs scanning signals to the multiplexer 111, causing it to sequentially select the sensing electrodes $L_1$ to $L_9$. It is to be noted that first the control circuit 211 controls the compensating circuit 122 in such a manner as to open all switch elements to disconnect all compensating capacitances (step 1).

The sensing circuit 115 outputs from its output terminal 115a signals of different voltage levels in synchronisation with the scanning of the electrodes $L_1$ to $L_9$ by the multiplexer 111. The differences between such voltage levels result from fluctuation (variation) of the capacitance values of sensing electrodes $L_1$ to $L_9$.

The control circuit 211 stores the level of the level meter 212 corresponding to the touch sensing electrode having a maximum capacitance value, as determined by the different voltage levels of the sequentially selected electrodes (step 2).

Thereafter, the control circuit 211 again supplies a scanning address signal to the multiplexer 111 causing it to select the touch sensing electrode 1 (step 3). At this time, the control circuit 211 gives an address signal also to the compensating circuit 122 in synchronisation with supply of the scanning address signal (step 4). The control circuit compares, at this time, the level of the level meter 212 with the stored level (step 5). If the levels do not match, the address signal for the compensating circuit 122 is counted up by one (step 6) and then supplied to the compensating circuit 122 (step 4). This causes compensating capacitance to be connected and when the level of level meter 212 matches the stored level the compensating circuit address signal is stored (step 7). Steps 5 and 6 are repeated, with successive increments of the connected compensating capacitance, until matching is achieved. When it is judged (step 8) that a cycle of the steps 4, 5, 6 and 7 has been performed but that storage of compensating data for all touch sensing electrodes is not yet completed, the address of address signal to the multiplexer 111 is counted up by one (step 9), followed by the similar operations. The compensating circuit address signals stored in steps 7 are transferred to the tape puncher 213 and punched onto tape TP. The data recorded on the tape TP is stored in the ROM 114 by means of the ROM writer 214.

Fig. 2(c) is a table indicating an example of data stored in a ROM 114. This table also indicates which compensating capacitor(s) in the compensating circuit is (are) selected in synchronisation with the selection of each touch sensing electrode, when the touch sensing electrode concerned is selected by the multiplexer and connected to the sensing circuit. For example, it is indicated that when the touch sensing electrode $L_1$ is selected by the multiplexer 111 and is connected to the sensing circuit, the ROM 114 outputs the data to the compensating circuit 122 causing it to select the compensating capacitors $C_1$, $C_2$, $C_3$ and $C_4$. Namely, in the tabulated example, the capacitance of electrode $L_1$ is 25 pF, and a compensating capacitance of 15 pF in total is added to that capacitance by the combination of compensating capacitors $C_1$, $C_2$, $C_3$ and $C_4$ in order to set the corrected capacitance to a reference capacitance value which is the maximum electrode capcitance—in this example 40 pF (capacitance of sensing electrode $L_4$).

In Figs. 2(a) and 2(b), only nine sensing electrodes are shown for simplification and clarity, but a touch panel can actually have several tens of electrodes or more corresponding to the characters or items on the display screen, and capacitance compensation is carried out corresponding to that number of electrodes.

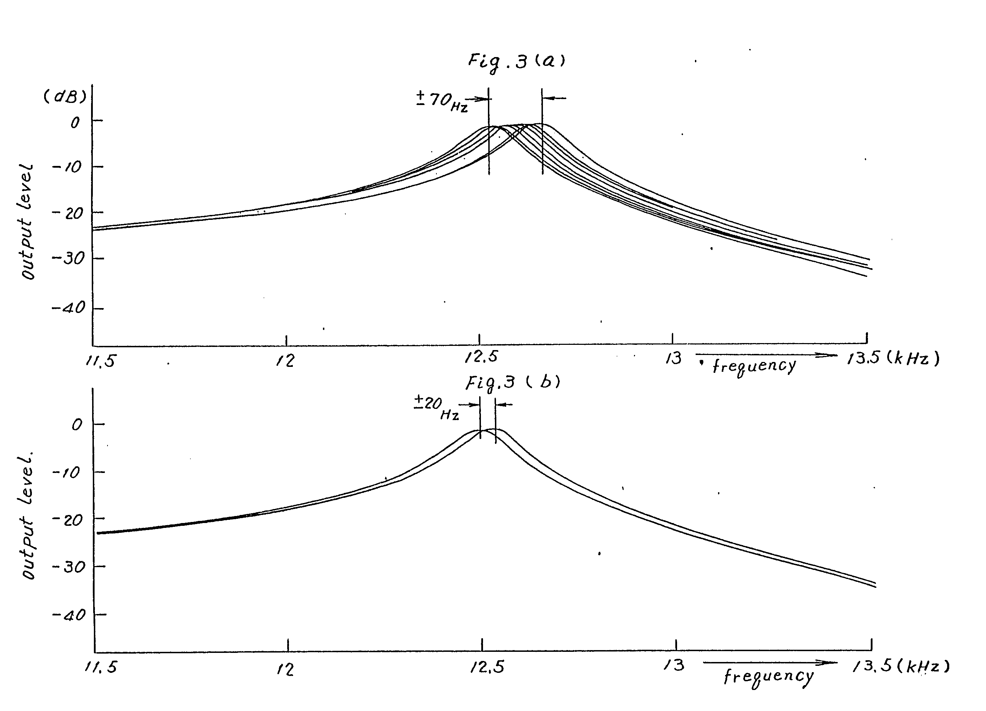

Fig. 3(a) is a graph illustrating the characteristic obtained when the relationship between output voltage level and frequency is measured for electrodes of a panel for example having 50 sensing electrodes, where fluctuation of capacitance values of touch sensing electrodes is not compensated. It will be seen that the resonant frequencies of the sensing electrodes differ from one another due to the different capacitance values of the touch sensing electrodes, and the difference between maximum resonant frequency for a sensing electrode and minimum resonant frequency for a sensing electrode can be a value as high as almost 140 (Hz).

Fig. 3(b) is a graph illustrating the characteristic relationship between output voltage and frequency obtained when capacitance compensation is carried out, in general accordance with the embodiment of the present invention shown in Fig. 1, for the same sensing panel as that of Fig. 3(a). In this case differences of capacitance values of the 50 touch sensing electrodes are compensated by the compensating circuit. It will be seen that since the capacitance values of the touch sensing electrodes are controlled by the ROM 114 so that they become practically equal, the resonant frequencies of touch sensing electrodes can all be set within the range of 20 (Hz). Therefore, the ON-OFF ratio, which is defined as the ratio of output voltage levels in touch and nontouch states, can be set uniformly for all electrodes, enabling the sensing of touch operations with high accuracy.

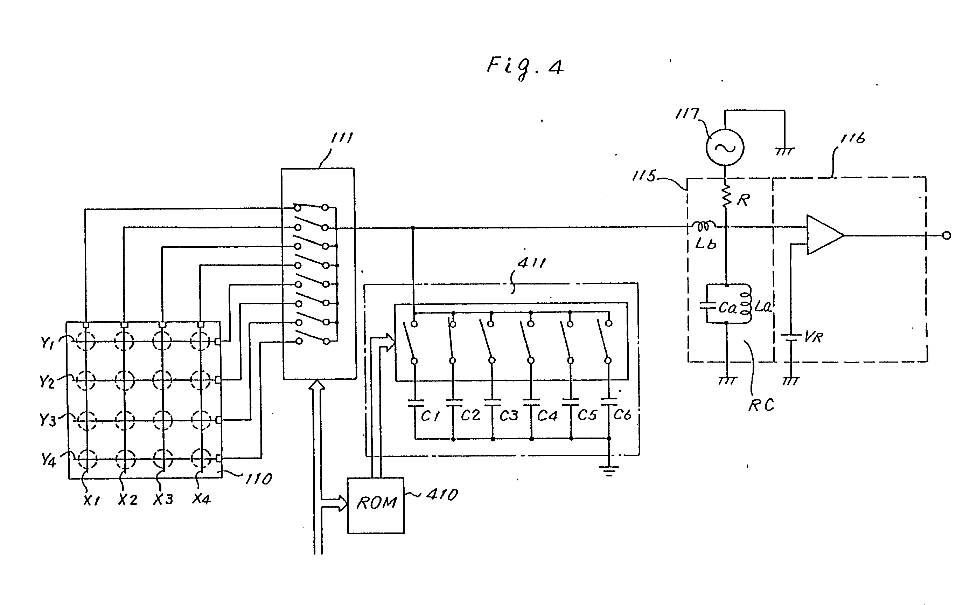

Fig. 4 is a block diagram illustrating a touch sensing device in accordance with another embodiment of the present invention.

The embodiment of Fig. 4 is the same as the embodiment of Fig. 1 insofar as the address signal which is input to the multiplexer 111 for the sequential scanning of the touch location sensing electrodes is input also to the ROM (410 in Fig. 4) and the compensating circuit (411 in Fig. 4) is controlled in accordance with the output condition of the ROM in response to such address signal.

However, the ROM 410 in Fig. 4 controls the compensating circuit 411 in such a manner as to select only one compensating capacitor at any one time. Namely, when one of the touch sensing electrodes is selected by the multiplexer 111, the ROM 410 outputs data so that a switch element corresponding to only one predetermined capacitor from amongst the plurality of compensating capacitors $C_1$ to $C_6$ in the compensating circuit 411 turns ON.

Where many sensing electrodes are provided and capacitances of electrodes differ over a wider range, it is advantageous to set the compensating capacitance through the use of combinations of compensating capacitors as shown in the embodiment of Fig. 2(a), but in case in which electrode capacitances differ only over a narrow range, it is profitable that a plurality of compensating capacitors $C_1$ to $C_6$ having different capacitances are provided as shown in Fig. 4 and that one of them (at most) is selected in correspondence to each electrode.

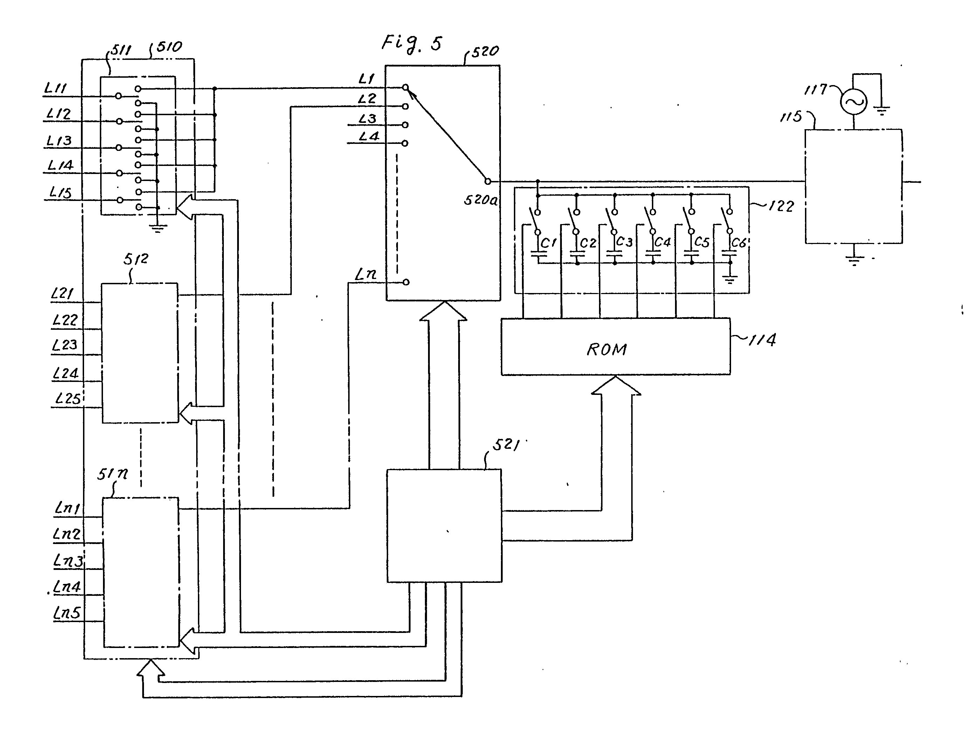

Fig. 5 is a block diagram illustrating a touch sensing device in accordance with a further embodiment of the present invention.

In this embodiment a plurality of touch sensing electrodes are divided into a plurality of blocks, and a touch operation is first detected in terms of block units, for ultimately detecting a touch of a touch sensing electrode. After block unit detection, scanning is carried out only for the limited number to touch sensing electrodes within one block, in order to raise the data retrieval rate.

In the embodiment of Fig. 5, an address control 521 supplies an address signal to an analog switch array 510. This address signal selects one analog switch sub-array from $n$ analog switch sub-arrays (or sub-analog switch arrays) 511 to 51n which are provided in array 510. The selected sub-array has five switches which are controlled by another address signal which is supplied in common to each sub-array (the non-selected subarrays are all connected to an earth terminal through their switches). The address signal supplied from the address control circuit 521 in common to each sub-array controls five switches, in accordance with the output state, so that the five switches may all be connected to an output terminal in common or so that they are connected individually and sequentially to the output terminal one by one. The multiplexer 520 connects any one of the block sensing electrodes $L_1$ to $L_n$ to its output terminal 520a in accordance with the output condition of an address signal sent from the address control circuit 521. The ROM 114 is controlled by the address signal sent from the address control circuit 521 in such a way as to select a compensating capacitor (or capacitors) in the compensating circuit 122 in synchronisation with the address signal of the sub-array, analog switch array and multiplexer. Thereby, it is possible to make the capacitance value effective when five touch sensing electrodes are connected to the sensing circuit 115 (for initial block selection and detection) equal to the capacitance value effective when a single sensing electrode is connected to the sensing circuit in order to sense touching of a single electrode within a block, by means of the compensating capacitors $C_1$ and $C_6$ of the compensating circuit 122.

Thus, touch sensing in the embodiment of Fig. 5 is carried out in two stages.

The first stage involves block unit detection in which all the electrodes (e.g. L11 to L15) forming a block connected to an addressed sub-array (e.g. 511) are connected in common to a respective block sensing electrode ($L_1$) which is in turn connected via the multiplexer 520 to the sensing circuit 115. This common connection is provided by appropriate addressing of switches within the addressed sub-array by address control circuit 521.

The compensating capacitors may be employed in this stage to provide all blocks of electrodes with the same effective capacitance.

The second stage involves detection of an individual touched electrode within a block identified in the first stage. In the second stage address signals are supplied to the switches of the sub-array concerned so as to connect each electrode of the block in turn to the sensing circuit 115.

The compensating capacitors may be employed in this stage to provide all the individual electrodes with the same effective capacitance, which can be made equal to the effective block capacitance established in the first stage.

As will be understood from the above, in embodiments of the present invention, differences between capacitance values of touch sensing electrodes are compensated by compensating capacitors common to all the touch sensing electrodes. Thereby the advantage is gained that the sensing sensitivity of sensing circuit can be improved and when the present invention is applied to a see-through type touch input device or touch keyboard, accurate and stable input can be designated. In addition, in embodiments of the present invention, capacitance compensation can be realised by simplified procedures and device cost can also be reduced as compared with that involved when individual compensating capacitors are connected to the corresponding sensing electrodes. It will be understood that the present invention can be applied to touch sensing devices other than see-through type touch sensing devices.

It will be understood that the present invention can be applied to touch sensing devices which sense a touch of an implement, rather than the human finger for example.

It will be further understood that the present invention can be applied using a compensating circuit using compensating elements, other than capacitors, as appropriate to compensate for differences in electrical characteristics of individual touch sensing electrodes (changes in electrical characteristics of which are brought about by touching of an electrode, for touch sensing.

An embodiment of this invention provides a touch sensing device having a sensing portion, which senses electrical characteristic (e.g. capacitance) changes of touch sensing electrodes forming a touch panel, a plurality of compensating elements (e.g. capacitors) which are used in common for the sensing electrodes in order to compensate for differences in characteristic (e.g. capacitance) between different touch sensing electrodes of the touch panel, and a ROM which stores data for selecting the compensating element(s) appropriate to each electrode.

The ON-OFF output voltage levels in the touch/non-touch conditions of the touch sensing electrodes can be equalised for all electrodes and thereby touch sensing with high accuracy can be realised by selecting the compensating elements by means of the ROM at the time of (reading) each touch sensing electrode.

Thus, the present invention provides a touch sensing device characterised in comprising a plurality of sensing electrodes arranged corresponding to the locations to be sensed and the sensing portion which senses change of electrical characteristics of the pertinent sensing electrode on the basis of designating operation to the desired sensing electrode, and moreover providing, in order to compensate fluctuation of electrical characteristics of said each sensing electrode, plurality of compensating circuit elements which are used as the common compensating circuit elements to each sensing electrode and the memory elements storing the data for selecting said compensating circuit elements corresponding to the compensated value in accordance with fluctuation of electrical characteristics of said each sensing electrode, and also selectively connecting, at the time of retrieving each sensing electrode, the elements corresponding to the compensated value in the compensating circuit corresponding to the retrieved sensing electrodes, in accordance with the data stored in the memory element.

**Claims**

1. A touch sensing device, comprising
   a plurality of touch electrodes each of which can be designated by an object, for example a human finger, to bring about a change in electrical characteristics associated with the electrode;
   a sensing portion to which the touch electrodes are selectively connectable, operable to sense a change in electrical characteristics when a touch electrode is designated by the object, the sensing portion comprising an oscillator, a parallel resonant circuit tuned to the oscillation frequency of the oscillator and connected to the oscillator via an impedance element, and a circuit for sensing voltage change at the connection point of the parallel resonant circuit and the impedance element, the touch electrodes being selectively connectable to that connection point;
   compensating circuitry, having compensating circuit elements selectively connectable to the sensing portion to compensate for unwanted differences in electrical characteristics between touch electrodes; and
   selection means operable to make selections of the compensating circuit elements, for connection to the sensing portion, appropriate to provide such compensation, in correspondence to selection of touch electrodes for connection to the sensing portion.

2. A device as claimed in claim 1, wherein the selection means comprise a memory storing data indicative of an appropriate selection of the compensating circuit elements, for providing such compensation, corresponding to each touch electrode selection, and means operable to connect that appropriate selection of the compensating circuit elements to the sensing portion in dependence upon the data stored in the memory, as each touch electrode selection is made.

3. A device as claimed in claim 1 or 2, operable to select the touch electrodes one by one in turn for connection to the sensing portion, the selection means being operable to make an appropriate selection of the compensating circuit elements, to compensate for unwanted differences in electrical characteristics between the individual touch electrodes, for each touch electrode so selected.

4. A device as claimed in claim 1, 2 or 3, operable to select the touch electrodes in groups, one by one in turn, each comprising a number of touch electrodes which are commonly connected to the sensing portion when the group is selected, the selection means being operable to make an appropriate selection of the compensating circuit elements to compensate for unwanted differences in electrical characteristics between the groups of touch electrodes, for each touch electrode group so selected.

5. A device as claimed in claim 4, wherein the selection means are operable, by appropriate selection of the compensating circuit elements, to provide each group of touch electrodes with effectively the same electrical characteristics as each individual touch electrode.

6. A device as claimed in any preceding claim, wherein a selection of the compensating circuit elements for connection to the sensing portion involves at most one compensating circuit element.

7. A device as claimed in any preceding claim wherein a selection of the compensating circuit elements for connection to the sensing portion can involve a plurality of compensating circuit elements.

8. A device as claimed in claim 7, wherein a first compensating circuit element has a unit compensating value, determined by reference to a minimum compensation required, and the other compensating circuit elements have compensating values which are obtained by multiplying the unit compensating value by respective powers of two.

9. A device as claimed in any preceding claim, wherein the compensating circuit elements are capacitors.

**Patentansprüche**

1. Berührungsempfindliche Vorrichtung mit einer Vielzahl von Berührungselektroden, von denen jede durch ein Objekt, z.B. einen menschlichen Finger, bestimmt werden kann, um eine Änderung der elektrischen Charakteristiken, die der Elektrode zugeordnet sind, herbeizuführen; einem fühlenden Abschnitt, mit dem die Berührungselektroden wahlweise verbindbar sind, der betreibbar ist, um eine Änderung der elektrischen Charakteristiken zu fühlen, wenn eine Berührungselektrode durch das Objekt bestimmt wird, welcher fühlende Abschnitt einen Oszillator, einen parallelen Resonanzkreis, der auf die Schwingfrequenz des Oszillators abgestimmt und mit dem Oszillator über ein Impedanzelement verbunden ist, und eine Schaltung zum Fühlen der Spannungsänderung an dem Verbindungspunkt des parallelen Resonanzkreises und des Impedanzelementes umfaßt, bei der die Berührungselektroden wahlweise mit dem genannten Verbindungspunkt verbindbar sind; einer Kompensationsschaltung, die Kompensationsschaltkreiselemente hat, welche wahlweise mit dem fühlenden Abschnitt verbindbar sind, um unerwünschte Differenzen in den elektrischen Charakteristiken zwischen den Berührungselektroden zu kompensieren; und Auswahleinrichtungen, die betreibbar sind, um die Kompensationsschaltkreiselemente auszuwählen, zur Verbindung mit dem fühlenden Abschnitt, die geeignet sind, solch eine Kompensation durchzuführen, entsprechend der Auswahl der Berührungselektroden zur Verbindung mit dem fühlenden Abschnitt.

2. Vorrichtung nach Anspruch 1, bei der die Auswahleinrichtungen einen Speicher umfassen, der Daten speichert, welche eine geeignete Auswahl der Kompensationsschaltkreiselemente anzeigen, um solch eine Kompensation, entsprechend jeder Berührungselektrodenauswahl, zu liefern, und Einrichtungen, die betreibbar sind, um die geeignete Auswahl der Kompensationsschaltkreiselemente mit dem fühlenden Abschnitt, in Abhängigkeit von den in dem Speicher gespeicherten Daten, zu verbinden, während jede Berührungselektrodenauswahl durchgeführt wird.

3. Vorrichtung nach Anspruch 1 oder 2, die betreibbar ist, um die Berührungselektroden, eine nach der anderen, zur Verbindung mit dem fühlenden Abschnitt auszuwählen, wobei die Auswahleinrichtungen betreibbar sind, um eine geeignete Auswahl der Kompensationsschaltkreiselemente durchzuführen, um unerwünschte Differenzen in den elektrischen Charakteristiken zwischen den einzelnen Berührungselektroden, für jede so ausgewählte Berührungselektrode, zu kompensieren.

4. Vorrichtung nach Anspruch 1, 2 oder 3, die betreibbar ist, um Berührungselektroden in Gruppen, jeweils eine nach der anderen, auszuwählen, wobei jede Gruppe eine Anzahl von Berührungselektroden umfaßt, die gemeinsam mit dem fühlenden Abschnitt verbunden sind, wenn die Gruppe ausgewählt wird, bei der die Auswahleinrichtungen betreibbar sind, um eine geeignete Auswahl der Kompensationsschaltkreiselemente durchzuführen, um unerwünschte Differenzen in den elektrischen Charakteristiken zwischen den Gruppen der Berührungselektroden, für jede so ausgewählte Gruppe von Berührungselektroden, zu kompensieren.

5. Vorrichtung nach Anspruch 4, bei der die Auswahleinrichtungen, durch geeignete Auswahl von Kompensationsschaltkreiselementen, betreibbar sind, um jeder Gruppe von Berührungselektroden effektiv dieselben elektrischen Charakteristiken wie jeder einzelnen Berührungselektrode zu verleihen.

6. Vorrichtung nach einem der vorhergehenden Ansprüche, bei der eine Auswahl von Kompensationsschaltkreiselementen zur Verbindung mit dem fühlenden Abschnitt höchstens ein Kompensationsschaltkreiselement umfaßt.

7. Vorrichtung nach einem der vorhergehenden Ansprüche, bei der eine Auswahl der Kompensationsschaltkreiselemente zur Verbindung des fühlenden Abschnitts eine Vielzahl von Kompensationsschaltkreiselementen umfassen kann.

8. Vorrichtung nach Anspruch 7, bei der ein erstes Kompensationsschaltkreiselement einen Einheitskompensationswert hat, der durch Referenz auf eine minimal erforderliche Kompensation bestimmt wird, und die anderen Kompensationsschaltkreiselemente kompensierende Werte haben, welche durch Multiplizieren des Einheitskompensationswertes mit entsprechenden Potenzen von zwei erhalten werden.

9. Vorrichtung nach einem der vorhergehenden Ansprüche, bei der die Kompensationsschaltkreiselemente Kondensatoren sind.

**Revendications**

1. Dispositif sensible à l'effleurement, comprenant:

un ensemble d'électrodes à effleurement dont chacune peut être indiquée par un objet, par exemple un doigt humain, pour entraîner un changement des caractéristiques électriques associées à l'électrode;

une partie de détection à laquelle les électrodes à effleurement peuvent être connectées sélectivement, pouvant être mise en fonctionnement pour détecter un changement des caractéristiques électriques quand une électrode à effleurement est indiquée par l'objet, la partie de détection comprenant un oscillateur, un circuit résonnant parallèle accordé à la fréquence d'oscillation de l'oscillateur et connecté à l'oscillateur par l'intermédiaire d'un élément d'impédance, et un circuit pour détecter une variation de tension au point de connexion du circuit résonnant parallèle et de l'élément d'impédance, les électrodes à effleurement pouvant être connectées sélectivement à ce point de connexion;

un ensemble de circuits de compensation, comportant des éléments de circuit de compensation pouvant être connectés sélectivement à la partie de détection pour compenser les différences non voulues de caractéristiques électriques entre les électrodes à effleurement; et

des moyens de sélection pouvant être mis en fonctionnement pour faire des sélections des éléments de circuit de compensation, pour une connexion à la partie de détection, appropriées pour assurer cette compensation, en correspondance avec la sélection des électrodes à effleurement pour une connexion à la partie de détection.

2. Dispositif selon la revendication 1, dans lequel les moyens de sélection comprennent une mémoire mémorisant les données indiquant une sélection appropriée des éléments de circuit de compensation, pour assurer cette compensation, correspondant à chaque sélection d'électrode à effleurement, et un moyen pouvant être mis en fonctionnement pour connecter cette sélection appropriée des éléments de circuit de compensation à la partie de détection selon les données mémorisées dans la mémoire, quand chaque sélection d'électrode à effleurement est faite.

3. Dispositif selon l'une quelconque des revendications 1 et 2, pouvant être mis en fonctionnement pour sélectionner les électrodes à effleurement une à une à leur tour pour une connexion à la partie de détection, les moyens de sélection pouvant être mis en fonctionnement pour faire une sélection appropriée des éléments de circuit de compensation, pour compenser les différences non voulues de caractéristiques électriques entre les électrodes à effleurement individuelles, pour chaque électrode à effleurement ainsi sélectionnée.

4. Dispositif selon l'une quelconque des revendications 1 à 4 pouvant être mis en fonctionnement pour sélectionner les électrodes à effleurement en groupes, une à une à leur tour, chaque groupe comprenant un certain nombre des électrodes à effleurement qui sont connectées en commun à la partie de détection quand le groupe est sélectionné, les moyens de sélection pouvant être mis en fonctionnement pour faire une sélection appropriée des éléments de circuit de compensation, pour compenser les différences non voulues de caractéristiques électriques entre les groupes d'électrodes à effleurement, pour chaque groupe d'électrodes à effleurement ainsi sélectionné.

5. Dispositif selon la revendication 4, dans lequel les moyens de sélection peuvent être mis en fonctionnement, par une sélection appropriée des éléments de circuit de compensation, pour donner à chaque groupe d'électrodes à effleurement effectivement les mêmes caractéristiques électriques que chaque électrode à effleurement individuelle.

6. Dispositif selon l'une quelconque des revendications 1 à 5, dans lequel une sélection des éléments de circuit de compensation pour une connexion à la partie de détection implique au plus un élément de circuit de compensation.

7. Dispositif selon l'une quelconque des revendications 1 à 6, dans lequel une sélection des éléments de circuit de compensation pour une connexion à la partie de détection peut impliquer un ensemble d'éléments de circuit de compensation.

8. Dispositif selon la revendication 7, dans lequel un premier élément de circuit de compensation a une valeur unitaire de compensation, déterminée en référence à une compensation minimale voulue, et les autres éléments de circuit de compensation ont des valeurs de compensation qui sont obtenues en multipliant la valeur unitaire de compensation par des puissances de deux respectives.

9. Dispositif selon l'une quelconque des revendications 1 à 8, dans lequel les éléments de circuit de compensation sont des condensateurs.

Fig.1

EP 0 093 565 B1

Fig. 2 (a)

**Fig.2 (b)**

START → STEP 1 → STEP 2 → STEP 3 → STEP 4 → STEP 5 → STEP 7 → STEP 8 → END

STEP 5 (≠) → STEP 6

STEP 8 (≠) → STEP 9

**Fig.2 (C)**

| sensing electrode | electrode capacitance [PF] | ROM | | | | | | adding capacitance [PF] | corrected capacitance [PF] |
|---|---|---|---|---|---|---|---|---|---|
| | | C1 1[PF] | C2 2[PF] | C3 4[PF] | C4 8[PF] | C5 16[PF] | C6 32[PF] | | |
| L1 | 25 | 1 | 1 | 1 | 1 | 0 | 0 | 15 | 40 |
| L2 | 18 | 0 | 1 | 1 | 0 | 1 | 0 | 22 | 40 |
| L3 | 28 | 0 | 0 | 1 | 1 | 0 | 0 | 12 | 40 |
| L4 | 40 | 0 | 0 | 0 | 0 | 0 | 0 | 0 | 40 |
| L5 | 32 | 0 | 0 | 0 | 1 | 0 | 0 | 8 | 40 |
| L6 | 26 | 0 | 1 | 1 | 1 | 0 | 0 | 14 | 40 |
| L7 | 35 | 1 | 0 | 1 | 0 | 0 | 0 | 5 | 40 |
| L8 | 38 | 0 | 1 | 0 | 0 | 0 | 0 | 2 | 40 |
| L9 | 33 | 1 | 1 | 1 | 0 | 0 | 0 | 7 | 40 |

Fig. 3 (a)

Fig. 3 (b)

EP 0 093 565 B1

Fig. 4

EP 0 093 565 B1

Fig. 5

EP 0 093 565 B1